Europäisches Patentamt

European Patent Office

Office européen des brevets

(11) Numéro de publication: **0 021 858**

**B1**

## (12) FASCICULE DE BREVET EUROPEEN

(45) Date de publication du fascicule du brevet: **10.04.85**

(21) Numéro de dépôt: **80400063.6**

(22) Date de dépôt: **15.01.80**

(51) Int. Cl.⁴: **H 01 L 47/00,** H 01 L 27/26, H 03 K 19/094

(54) **Circuit logique inverteur comportant des éléments semiconducteurs utilisant l'effet de saturation.**

(30) Priorité: **13.02.79 FR 7903639**

(43) Date de publication de la demande:
**07.01.81 Bulletin 81/01**

(45) Mention de la délivrance du brevet:
**10.04.85 Bulletin 85/15**

(84) Etats contractants désignés:
**DE GB NL**

(56) Documents cités:
**FR-A-1 455 145**
**FR-A-1 560 104**
**US-A-3 487 338**
**US-A-3 805 125**

**IEEE Transactions on Ed. Vol. ED-27, no. 6, juin 1980, K. Lehovec et al, p. 1074-1091**

(73) Titulaire: **THOMSON-CSF**
**173, Boulevard Haussmann**
**F-75379 Paris Cedex 08 (FR)**

(72) Inventeur: **Pham, Ngu Tung**
**"THOMSON-CSF" - SCPI 173, Bld Haussmann**
**F-75360 Paris Cedex 08 (FR)**
Inventeur: **Nuzillat, Gérard**
**"THOMSON-CSF" - SCPI 713, bld Haussmann**
**F-75360 Paris Cedex 08 (FR)**

(74) Mandataire: **Lepercque, Jean et al**
**THOMSON-CSF SCPI 173, Bld Haussmann**
**F-75379 Paris Cedex 08 (FR)**

Courier Press, Leamington Spa, England.

## Description

L'invention concerne un circuit logique inverseur utilisant des transistors à effet de champ du type "normalement bloqué" (voir la définition ci-après), dont la structure peut être utilisée en l'absence de grille de commande comme une résistance saturable.

A l'heure actuelle tous les circuits intégrés sur As Ga (Arseniure de Gallium) sont réalisés à partir de transistor à effet de champ à jonction (JFET) ou à grille Schottky (MESFET).

Les transistors sont de deux types: les transistors normalement conducteurs, où l'on bloque le courant drain-source par pincement du canal normalement existant (transistors à déplétion) par application d'une tension appropriée et les transistors normalement fermés où l'on ouvre le canal par une tension de grille appropriée, (transistors à enrichissement).

Les premiers de ces transistors présentent l'inconvénient d'une forte consommation. De plus, les polarités des tensions d'entrée $V_{GS}$ (différence de potentiel grille-source) et de sortie $V_{DS}$ (différence de potentiel drain-source) sont opposées. Pour un canal de type n, la tension de blocage est négative, alors que la tension d'alimentation est positive. Il en résulte qu'il doit y avoir deux sources d'alimentation.

Dans les transistors du second type, il faut maîtriser la valeur de la tension de seuil, tension minimale de déblocage et donc du dopage et de l'épaisseur de la zone active (zone où se forme le canal). La réalisation est très délicate et les déchets de fabrication très importants.

Un paramètre important des transistors à effet de champ est celui de la tension de déchet $V_{De'chet}$ qui est la tension drain-source résiduelle quand le transistor est à l'état passant.

Dans les circuits de l'Art Connu, le blocage d'un transistor d'entrée d'un circuit logique ne peut être réalisé que si $V_T \gtrsim V$ déchet.

Ces circuits ne peuvent donc être réalisables qu'avec des seuiles nettement positifs de l'ordre de 0,2 V soit 150 à 200 mV. Dans les circuits selon l'invention, cette condition n'existe plus.

L'invention permet de s'affranchir des inconvénients mentionnés ci-avant, grâce à une structure du type "canal creusé". Cette structure comporte, sur un substrat semi-isolant, une couche de matériau semi-conducteur de nature et de dopage tels que le matériau est susceptible de présenter, pour un champ électrique donné, l'existence d'un domaine dipolaire, et sur cette couche deux contacts ohmiques.

L'invention a donc pour objet un circuit logique inverseur tel que défini par les revendications 1 à 3.

L'invention sera mieux comprise au moyen de la description ci-après en se référant aux dessins annexés parmi lesquels:

— les figures 1 et 2 représentent en coupe deux exemples de résistances présentant une structure à canal creusé utilisée dans l'invention;
— les figures 3 et 4 représentent deux exemples de réalisation de transistors à effet de champ utilisant une structure à canal creusé utilisée dans l'invention;
— les figures 5 et 6 sont des diagrammes explicatifs;
— les figures 7 à 11 représentent une structure a canal creusé au cours des diverses ètapes de sa fabrication;
— la figure 12 représente un premier exemple de circuit logique inverseur selon l'invention;
— les figures 13 et 14 représentent le circuit de la figure 12 dans deux états logiques;
— les figures 15 et 16 représentent respectivement les schémas des deux autres variantes de réalisation de circuits logiques inverseurs selon l'invention.

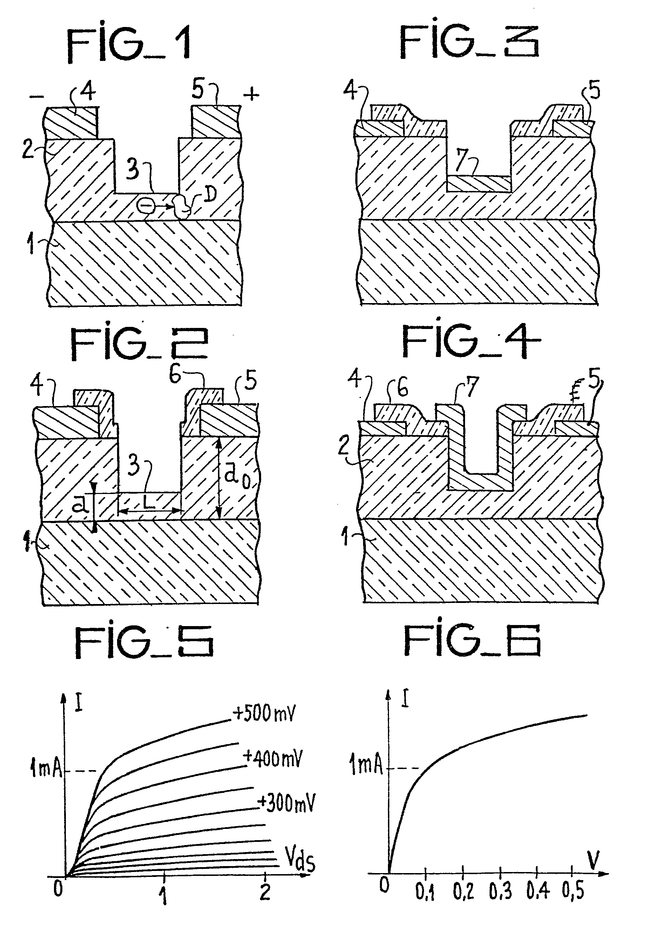

Sur les figures 1 et 2, on voit en 1, un substrat logique semi-isolant en Arseniure de Gallium (Ga As), en 2 une couche épitaxiale en même matériau dopé par une impureté de type de conductivité N, en 4 et en 5 sur cette couche deux contacts ohmiques.

Entre les contacts 4 et 5 a été creusée une tranchée 3 d'épaisseur a (épaisseur de la couche active $a_o$). Sur la figure 2, l'ensemble est recouvert partiellement d'une couche de silice 6, qui protège le bord des contacts ohmiques.

Il a été découvert, dans les laboratoires de la demanderesse que, dans certaines conditions, qui seront précisées plus loins, le courant entre contacts ohmiques atteint rapidement une valeur de saturation, $I_S$ qui est pratiquement une constante pour un matériau donné, l'arseniure de gallium par exemple, et une configuration géomètrique donnée, par exemple avec les dimensions suivantes:

a=profondeur du canal résiduel (de l'ordre de 0,1 μ)
L=longueur du canal (de l'ordre du micron)
Z=largeur du canal (de l'ordre de 10 à 100 μ)
Une formule empirique a été établie:

$$I_S = \gamma (V_o)^2 Z \qquad (1)$$

dans laquelle γ est un coefficient caractéristique du matériau (40 microampères par volt et par micron de longueur Z dans le cas de l'arseniure de gallium) et $V_c$ est défini comme suit:

$V_c$ est la tension de coude de la courbe de saturation, c'est-à-dire la tension entre contacts ohmiques pour laquelle le courant atteient une valeur très proche de la valeur à la saturation.

On observe que $V_c$, comme $I_s$, est remarquablement constant pour un matériau donné et une configuration donnée dans une fabrication collective de dispositifs présentant la structure selon l'invention.

On a proposé la décomposition suivant de la tension $V_c$:

$$V_c = V_X - V_T \qquad (2)$$

dans laquelle $V_X$ est la tension entre les bords du canal lorsque le champ E atteint la valeur critique $E_c$ pour le le matériau. On a:

$$V_X = E_c \, L \qquad (3)$$

D'autre part, $V_T$ est la tension de seuil ou de pincement. En effet, dans un transistor à effet de champ (même dans une structure sans grille ce qui est le cas dans la structure de l'invention) il existe une certaine charge d'espace dans le canal, ce qui explique qu'il y ait des transistors du type "normalement bloqué". C'est cette charge d'espace qui explique l'introduction du terme $V_T$.

Cette tension de seuil, pour les ordres de grandeur précisés plus haut en ce que concerne le matériau et la configuration, est:

$$-0,5 \leqslant V_T \leqslant +0,2 \text{ volt}$$

Exemple de calcul pour $I_s$:
pour:

a=0,1 μ
L=1 μ
Z=20 μ

on a, dans le cas de l'arseniure de gallium dopé n à $10^{17}$ at/cm³

$V_X = 3\ 300$ V/cm$\times 10^{-4}$ cm=0,33 volt
$V_T = -0,2$ volt
$V_c = 0,53$ volt
$I_s = 40\ (0,53)^2 \cdot 20 = 224$ microampères.

On remarque la petitesse de ce courant de saturation, particulièrement intéressante lorsqu'on recherche de très faibles consommations. La réalisation d'une telle structure est parfaitement possible en utilisant l'usinage ionique.

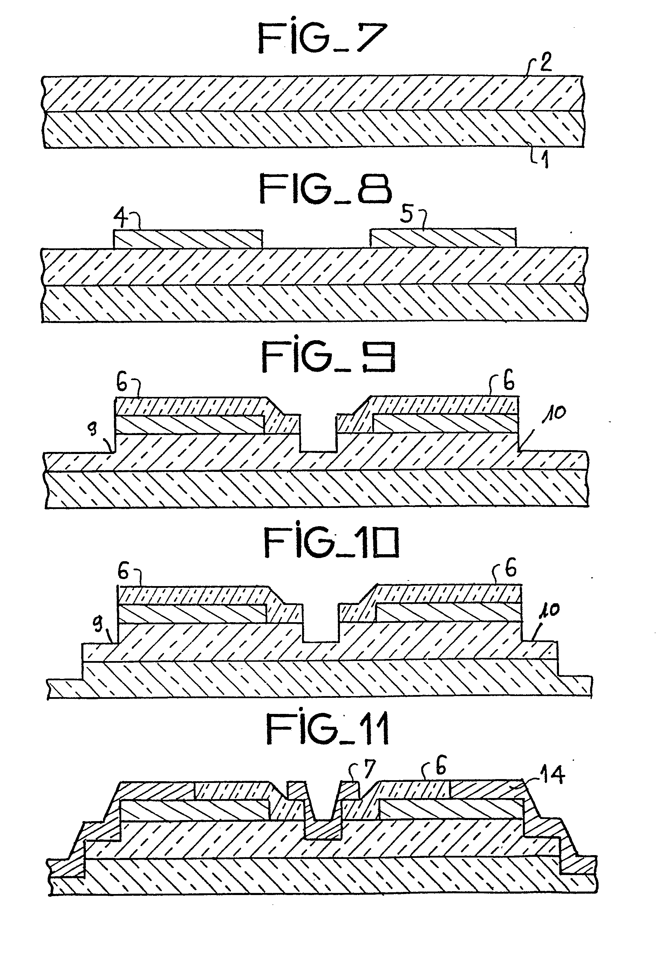

Les figures 3 et 4 représentent respectivement en coupe deux transistors à effet de champ et grille schottky utilisant la structure selon l'invention. Les mêmes références désignent les mêmes objets que sur les figures précédentes. Les bornes 4 et 5 sont respectivement la source et le drain de ces transistors. Un dépôt métallique 7 constitue la grille du transistor.

Les figures 5 et 6 sont des exemples de caractéristiques courant I—tension V pour les éléments des figures 1 et 2, et les réseaux de caractéristiques I=f($V_{ds}$) pour différentes tensions appliquées à la grille pour les éléments des figures 3 et 4.

Les figures 7 et suivantes montrent les étapes de fabrication des résistances saturables et des transistors que l'on vient de décrire.

Sur la figure 7, on a fait croître par épitaxie sur le substrat isolant 1, la couche active 2, dopée N avec une densité d'impurités de $10^{17}$ at/cm³, et de 2 500 angströms d'épaisseur.

Sur la figure 8, par tout moyen approprié (masquage électronique, etc...) ont été déposés les deux contacts ohmiques 4 et 5 (bornes d'une résistance, source et drain d'un transistor).

Sur la figure 9, un masque de silice 6 a été formé, pour délimiter la tranchée servant de canal, pour protéger la surface des transistors ou les bornes des résistances sur les espaces compris entre ceux-ci et le canal; ce masquage a permis de former le canal 7 par un procédé d'attaque chimique classique.

Figure 10, en 10 et 11 a été pratiquée une attaque "mésa", par exemple à travers un masque d'aluminium recouvrant toute la surface des transistors; l'aluminium résiduel a été éliminé, après usinage, par attaque chimique sélective.

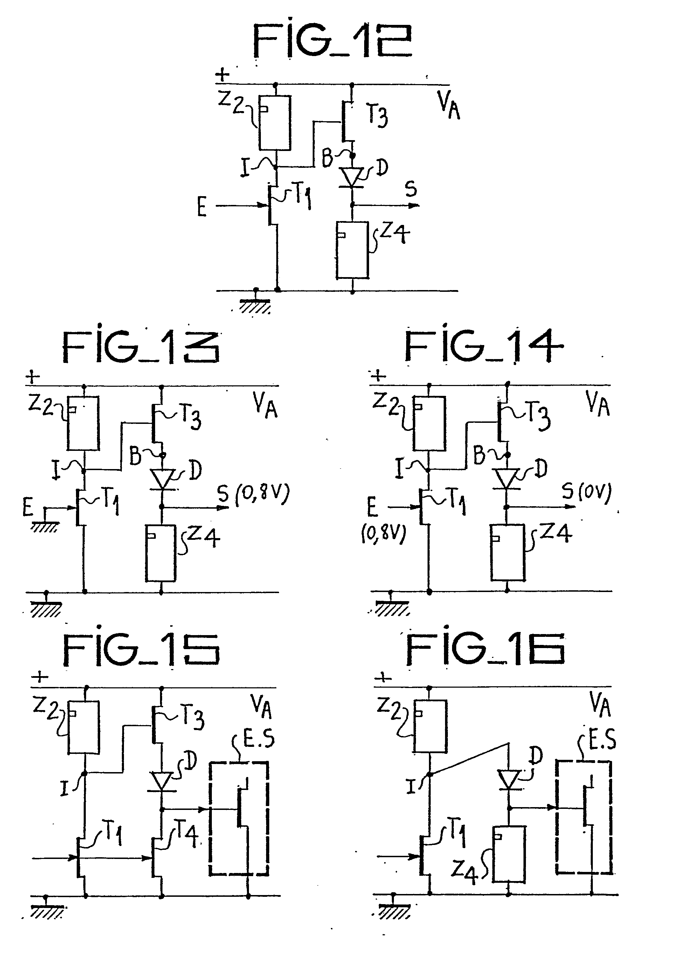

Figure 11, l'usinage des tranchées a été faite. Pour obtenir des flancs abrupts, on a utilisé l'usinage ionique. L'énergie d'érosion est assez faible (100 KeV à 500 KeV). La profondeur du canal peut être contrôlée par la mesure sous tension constante du courant entre les contacts ohmiques.

Enfin est pratiqué dans la tranchée, si on veut obtenir un transistor à effet de champ, le dépôt d'une grille Schottky 7, par dépôts successifs de titane, platine et or ainsi que le dépôt d'un mital 17 assurant le contact vers les Bonns 7 et 5.

Les figures suivantes représentent des circuits logiques inverseurs selon l'invention utilisant les structures qui viennent d'être décrites.

Certains inverseurs à effet de champ comportant des transistors à enrichessement présentent l'avantage que les transistors étant normalement bloqués, ils ne sont débloqués que par l'application sur la grille de tensions de même polarité que la tension d'alimentation.

Ils présentent néanmoins l'inconvénient d'être difficiles à réaliser, le contrôle des paramètres de la couche active devant être extrêmement rigoureux. De plus, l'utilisation de transistors à source et grille interconnectées comme résistances saturables est incompatible avec ce type de transistor.

Dans le cas de l'invention, les résistances saturables et les transistors à tranchée à enrichissement peuvent être fabriqués simultanément. De plus, la tension de seuil $V_T$ des transistors à effet de champ peut être contrôlée en cours de fabrication comme on l'a vu plus haut.

Sur la figure 12 est représenté un circuit inverseur logique selon une première variante de réalisation de l'invention dont l'entrée logique E est connectée à la grille d'un transistor $T_1$, dont la source est à la masse, le drain connecté à un point I, lui-même connecté à la source d'alimentation $V_A$ par une résistance saturable $Z_2$.

Le transistor $T_1$ est du type de celui d'une des figures 3 ou 4, et la résistance saturable du type de celui des figures 1 et 2.

Le point I est relié à la grille d'un transistor $T_3$ identique au précédent; ce transistor a son drain connecté à $V_A$, sa source B a une diode D passante de $V_A$ à la masse, l'autre borne de la diode D est connectée à la masse par une résistance $Z_4$ de même type que la résistance $Z_2$.

A titre d'exemple la largeur Z du canal (ou longueur de la tranchée) est de 40 µm pour les structures de $T_1$, $T_3$ et $Z_4$ et de 20 µm dans la structure de $Z_2$. D'une façon générale la largeur de la structure de $Z_2$ doit être plus petite que celle de $T_1$. En outre, on a le circuit logique optimal quand les structures de $T_1$, $T_3$ et $Z_4$ sont de même largeur de canal.

Le fonctionnement se comprendra à l'aide des figures 13 et 14.

Tout d'abord, il faut souligner qu'un paramètre important des transistors à effet de champ décrits est celui de la tension de déchet $V_{De\cdot chet}$ qui est la tension drain-source résiduelle quand le transistor est à l'état passant.

Dans les circuits connus, le blocage d'un transistor d'entrée d'un circuit logique ne peut être réalisé que si $V_T \gtrsim V$ déchet.

Ces circuits ne peuvent donc être réalisables qu'avec des seuils nettement positifs de l'ordre de 0,2 V soit 150 à 200 mV. Dans les circuits qui sont et vont être décrits cette condition n'existe plus.

Figure 13, l'entrée E est à la masse, état "0", le transistor $T_1$ est bloqué, le potentiel au point I est voisin de $V_A$, la jonction grille-source du transistor $T_3$ est polarisée en direct, le potentiel au point B (source du transistor $T_3$) tend à monter à $V_A$. Le potentiel à la sortie S ne peut pas monter au dessus de 0,8 V, du fait qu'il est connecté à la porte d'entrée de l'étage suivant, (identique à celui de la figure 13) et que la chute de tension aux bornes de la jonction grille-source du transistor $T_1$, qui dans ce cas est passante, est de l'ordre de 0,8 V.

La tension Vδ aux bornes de la diode D qui est passante est également de l'ordre de 0,8V. Le courant de sortie est limité par le résistance $Z_2$.

Figure 14, la grille du transistor $T_1$ est portée au niveau "1" (0,8 V sensiblement) limitée par la polarisation en direct de la jonction grille-source.

Par définition le potentiel au point I est la tension $V_{de\cdot chet}$ du transistor $T_1$ qui est passant.

Ceci tend à bloquer le transistor $T_3$; le courant dans l'ensemble $T_3$—D—$Z_4$ restera très faible.

La sortie S est prise en pont entre la diode D et la résistance $Z_4$. Or, la résistance $Z_4$ a une valeur très faible, et la résistance de la diode pour un potentiel très faible dans le sens passant appliqué entre se ses bornes est nettement plus élevée. C'est donc la diode qui prend en compte tout le potentiel résiduel entre B et la masse; la sortie S a donc sa sortie calée sur la masse.

Du fait de la caractéristique très non-linéaire de la diode au voisinage de sa tension de coude, il suffit d'un courant très faible dans l'ensemble $T_3$—$T_3$—D—$Z_4$ pour que cet effet se produise.

Il en résulte que dans l'inverseur considéré, la condition $V_T$ très voisin de 0 mais essentiellement positif n'est plus nécessaire et qu'il suffira que l'inégalité $V_T \gtrsim V_{de\cdot chet} - V\delta_o$ soit respectée, $v\delta_o$ étant la valeur de la tension de coude de la diode D. $V_T$ pourra même être négatif puisque la tension de coude de la diode est voisine de 0,5 V. $V_T$ pourra être supérieur non pas à V déchet mais à—0,3 V.

Avec plusieurs diodes en série, deux par exemple, on arriverait à des résultats tels que $V_T > -0,8$ V.

En résumé, c'est essentiellement la présence de la diode D, quoique toujours polarisée en direct, qui permet d'augmenter la gamme des tensions de seuil vers des valeurs faibles et même négatives, et qui cale la sortie au niveau bas; la tension de déchet des transistors n'est plus déterminanté.

Figure 15, on a représenté une variante du circuit logique de la figure 12 où un transistor $T_4$, replacant $Z_4$, a sa grille connecté en parallèle avec la grille du transistor $T_1$; le reste du montage étant inchangé. Ce montage présente les avantages suivantes.

Le courant dans le transistor $T_4$ quand il est bloqué (état "0" à l'entrée) est réduit par rapport à ce qu'il est dans la résistance $Z_4$ des figures précédentes. Néanmoins, dans cet état, la chute de potentiel se produit essentiellement dans la diode D.

A titre d'exemple, les performances mesurées sur un oscillateur en anneau formé de 11 inverseurs du type de la figure 15 sont les suivantes:

| | | |
|---|---|---|
| $V_A$=1,4 V | $t_{pd}$=300 ps | p=360 µW |
| $V_A$=2,4 V | $t_{pd}$=110 ps | p=2 mW |
| $V_A$=3,4 V | $t_{pd}$= 95 ps | p=4,5 mW |

pour:

$N=1,5.10^{17}$ cm$^{-3}$;    L=1 µm;    $X_{SD}$=3 µm

avec N dopage de la zone active, L longueur du canal (fig. 2) $X_{SD}$ distance source-drain de chaque composant.

En outre, on a:

$Z(T_1) = Z(Z_2) = Z(T_4) = 35$ µm

$Z(T_3) = Z(D) = 40$ µm

Z étant la largeur de chaque élément (figurant entre parenthèses).

Une autre variant est représentée sur la figure 16. Par rapport au montage de la figure 12, le transistor $T_3$ a été supprimé, ce qui conduit à une densité d'intégration plus élevée. La condition à réaliser sur les différents courants est la suivante:

$I(Z_2) > I_{DSS}(T_1) + I(Z_4)$

$I(Z_2) \ I_{max}(T_1) + I(Z_4)$

$I_{DSS}(T_1)$ étant le courant de saturation de $T_1$ à $V_{GS}$=0 (nul pour un MESFET à enrichissement) et $I_{max}(T_1)$ le courant maximum de $T_1$ pour l'entrée dans l'état haut. $I(Z_1)$ le courant dans la résistance $Z_4$.

Ce montage a l'inconvénient de consommer dans les deux états.

**Revendications**

1. Circuit logique inverseur, caractérisé en ce qu'il comprend, réalisé sur un substrat commun semiconducteur isolant (1) et disposés entre deux bornes d'une alimentation commune:

— un étage d'entrée comportant, en série, un premier transistor ($T_1$) à effet de champ à contact Schottky du type à canal résiduel et une première résistance saturable ($Z_2$) intercalée, côté drain dudit premier transistor ($T_1$), dans le circuit d'alimentation ($V_A$) de ce transistor;

— et un étage de sortie comportant, en série, un deuxième transistor ($T_3$), identique au premier, dont le contact Schottky est relié au drain du premier transistor ($T_1$) et le drain relié à la borne d'alimentation ($V_a$) de la première résistance saturable ($Z_2$), une diode (D) polarisée dans le sens passant et une seconde résistance saturable ($Z_4$);

l'entrée (E) du circuit logique étant prise sur le contact Schottky du premier transistor ($T_1$), et sa sortie (S) étant prise entre la diode (D) et la deuxième résistance saturable ($Z_4$);

et en ce que chaque résistance saturable ($Z_2$, $Z_4$) est réalisée sur ledit substrat commun semi-isolant (1), dans une couche de matériau semiconducteur (2) de nature et de dopage tels que le matériau est susceptible de présenter, pour un champ électrique supérieur à une valeur dite critique, l'existence d'un domaine dipolaire; et comporte sur cette couche, deux contacts ohmiques (4, 5) et entre ces contacts une tranchée (3) creusée dans la couche de matériau semiconducteur (2), de manière à délimiter un canal résiduel dans le matériau, canal dont les dimensions (L, a, Z) sont telles que la valeur critique du champ électrique est dépassée pour une valeur de l'ordre du volt de la tension entre les contacts ohmiques (4, 5).

2. Circuit logique inverseur selon la revendication 1, caractérisé en ce qu'un troisième transistor ($T_4$), également identique au premier transistor ($T_1$), est substitué à la deuxième résistance saturable ($Z_4$), et en ce que le contact Schottky de ce transistor est relié au contact Schottky du premier transistor ($T_1$).

3. Circuit logique inverseur selon la revendication 1, caractérisé en ce que le deuxième transistor ($T_3$) est remplacé par la première résistance saturable ($Z_2$) formant charge commune pour les étages d'entrée et de sortie, ladite diode (D) étant reliée directement au point commun (I) entre le drain du premier transistor ($T_1$) et la première résistance saturable ($Z_2$).

4. Circuit logique selon l'une quelconque des revendications 1 à 3, caractérisé en ce que le matériau semiconducteur est de l'arséniure de gallium.

5. Circuit logique selon l'une quelconque des revendications 1 à 3, caractérisé en ce que le dopage est de type N.

**Patentansprüche**

1. Invertierende Logikschaltung, dadurch gekennzeichnet, daß sie auf einem gemeinsamen isolierenden Halbleitersubstrat (1) verwirklicht und zwischen zwei Anschlüssen einer gemeinsamen Versorgung umfaßt:

— eine Eingangsstufe, die in Reihenschaltung einen ersten Feldeffekttransistor ($T_1$) mit Schottkykontakt und vom Restkanaltyp und einen ersten sättigbaren Widerstand ($Z_2$) umfaßt, die auf der Drain-Seite des ersten Transistors ($T_1$) in den Versorgungskreis ($V_A$) dieses Transistors eingefügt ist;

— und eine Ausgangsstufe, die in Reihenschaltung einen zweiten, mit dem ersten identischen Transistor ($T_3$), dessen Schottkykontakt mit dem Drain des ersten Transistors ($T_1$) und dessen Drain mit dem Versorgungsanschluß ($V_a$) des ersten sättigbaren Widerstandes ($Z_2$) verbunden ist, eine in Durchlaßrichtung gepolte Diode (D) und einen zweiten sättigbaren Widerstand ($Z_4$) umfaßt;

wobei der Eingang (E) der Logikschaltung an den Schottkykontakt des ersten Transistors ($T_1$) gelegt ist und ihr Ausgang (S) zwischen der Diode (D) und dem zweiten sättigbaren Widerstand ($Z_4$) abgegriffen wird;

und daß jeder sättigbare Widerstand ($Z_2$, $Z_4$) auf dem genannten gemeinsamen halbisolierenden Substrat (1) in einer Halbleitermaterialschicht (2) gebildet ist, deren Art und Dotierung der Art sind, daß in dem Material für ein elektrisches Feld, welches einen sogenannten kritischen Wert überschreitet, ein Dipolgebiet auftreten kann; und auf dieser Schicht zwei Ohmsche Kontakte (4, 5) sowie zwischen diesen Kontakten einen Graben (3) umfaßt, der aus der Halbleitermaterialschicht (2) derart herausgearbeitet ist, daß ein Restkanal in dem Material begrenzt wird, dessen Abmessungen (L, a, Z) der Art sind, daß der kritische Wert des elektrischen Feldes überschritten wird für einen Spannungswert zwischen den Ohmschen Kontakten (4, 5) in der Größenordnung von einem Volt.

2. Invertierende Logikschaltung nach Anspruch 1, dadurch gekennzeichnet, daß ein dritter Transistor ($T_4$), der ebenfalls identisch mit dem ersten Transistor ($T_1$) ist, an die Stelle des zweiten sättigbaren Widerstandes ($Z_4$) tritt und daß der Schottkykontakt dieses Transistors mit dem Schottkykontakt des ersten Transistors ($T_1$) verbunden ist.

3. Invertierende Logikschaltung nach Anspruch 1, dadurch gekennzeichnet, daß der zweite Transistor ($T_3$) ersetzt ist durch den ersten sättigbaren Widerstand ($Z_2$), der eine gemeinsame Belastung für die Eingangs- und die Ausgangsstufe bildet, wobei die genannte Diode (D) direkt mit dem Verbindungspunkt (I) zwischen dem Drain des ersten Transistors ($T_1$) und dem ersten sättigbaren Widerstand ($Z_2$) verbunden ist.

4. Logikschaltung nach einem der Ansprüche 1 bis 3, dadurch gekennzeichnet, daß das Halbleitermaterial Galliumarsenid ist.

5. Logikschaltung nach einem der Ansprüche 1 bis 3, dadurch gekennzeichnet, daß die Dotierung vom N-Typ ist.

## Claims

1. Logic inverter circuit, characterized in that it comprises, formed on a common insulating semiconductor substrate (1) and arranged between two terminals of a common supply:

— an input stage comprising, in series, a first field effect transistor $(T_1)$ having a Schottky contact and of the residual channel type, and a first saturable resistor $(Z_2)$ inserted into the supply circuit $(V_A)$ of said first transistor $(T_1)$ on the drain side thereof;
— and an output stage comprising, in series, a second transistor $(T_3)$ identical to the first and the Schottky contact of which is connected to the drain of the first transistor $(T_1)$ and its drain being connected to the supply terminal $(V_a)$ of said first saturable resistor $(Z_2)$, a diode (D) biased into the conducting sense and a second saturable resistor $(Z_4)$;

the input (E) of the logic circuit being taken on the Schottky contact of the first transistor $(T_1)$ and its output (S) being derived between the diode (D) and the second saturable resistor $(Z_4)$; and in that each saturable resistor $(Z_2, Z_4)$ is formed on the common semi-insulating substrate (1) in a semiconductor material layer (2) of such nature and doping that the material is susceptible to present the existence of a dipole domain for an electric field exceeding a so-called critical value; and comprises on this layer two ohmic contacts (4, 5) and between these contacts a trench (3) worked into the layer of semiconductor material (2) in a manner to define a residual channel in the material, this channel having such dimensions (L, a, Z) that the critical value of the electric field is exceeded for a value in the order of one volt of the voltage between the ohmic contacts (4, 5).

2. Logic inverter circuit according to Claim 1, characterized in that a third transistor $(T_4)$, also identical to the first transistor $(T_1)$, is substituted for the second saturable resistor $(Z_4)$, and in that the Schottky contact of this transistor is connected to the Schottky contact of the first transistor $(T_1)$.

3. Logic inverter circuit according to Claim 1, characterized in that the second transistor $(T_3)$ is replaced by the first saturable resistor $(Z_2)$ forming a common load of the input and output stages, said diode (D) being directly connected to the common point (I) between the drain of the first transistor $(T_1)$ and the first saturable resistor $(Z_2)$.

4. Logic circuit according to any of Claims 1 to 3, characterized in that the semiconductor material is gallium arsenide.

5. Logic circuit according to any of Claims 1 to 3, characterized in that the doping is of N-type.

0 021 858

FIG_1

FIG_3

FIG_2

FIG_4

FIG_5

FIG_6

## FIG_7

## FIG_8

## FIG_9

## FIG_10

## FIG_11

# FIG_12

# FIG_13

# FIG_14

# FIG_15

# FIG_16